# EUROPÄISCHE PATENTANMELDUNG

(11) **EP 0 540 820 A1**
(43) Veröffentlichungstag der Anmeldung: **12.05.1993**
(21) Anmeldenummer: 92111100.1
(22) Anmeldetag: 01.07.1992
(51) Int. Cl.: H01C 17/06, H01C 7/00

(54) **Verfahren zur Herstellung eines strukturierten Dünnfilm-Widerstandsschichtsystems sowie Schaltungsanordnung mit einem insbesondere nach diesem Verfahren hergestellten Dünnfilm Widerstandsschichtsystem**

(30) Priorität: 02.11.1991 DE 4136198
(71) Anmelder: Daimler-Benz Aerospace Aktiengesellschaft, D-81663 München (DE)
(72) Erfinder: Feurer, Ernst, Dr., W-7906 Blaustein (DE); Holl, Bruno, Dr., W-7900 Ulm (DE)
(74) Vertreter: Schulze, Harald Rudolf, Dipl.-Ing.

(57) **Zusammenfassung**

Die Erfindung bezieht sich auf ein Verfahren zur Herstellung eines strukturierten Dünnfilm-Widerstandsschichtsystem auf einem dielektrischem Substrat, bei welchem Verfahren in einem Vakuumprozeß eine erste Widerstandsschicht mit einem hohen Flächenwiderstand, eine zweite Widerstandsschicht mit einem niedrigen Flächenwiderstand und eine elektrisch gut leitende Leitschicht auf das Substrat aufgebracht werden.

Um den Verfahrensablauf möglichst einfach und kostengünstig zu gestalten, wird nach der Erfindung vorgeschlagen, daß eine Nickel-Chrom(NiCr)-Widerstandsschicht als erste Widerstandsschicht und eine Wolfram-Titan(WTi)-Widerstandsschicht als zweite Widerstandsschicht auf das dielektrische Substrat aufgebracht werden. Außerdem wird eine Schaltungsanordnung mit einem insbesondere nach diesem Verfahren hergestellten Widerstandsschichtsystem angegeben.

## Beschreibung

Die Erfindung bezieht sich auf ein Verfahren zur Herstellung eines strukturierten Dünnfilm-Widerstandsschichtsystems nach dem Oberbegriff des Patentanspruchs 1 sowie auf eine Schaltungsanordnung mit einem insbesondere nach diesem Verfahren hergestellten Dünnfilm-Widerstandsschichtsystem nach dem Oberbegriff des Patentanspruchs 8.

Ein solches Verfahren bzw. ein solches Dünnfilm-Widerstandsschichtsystem ist bereits bekannt aus dem Artikel "Entwicklungen in der Dünnfilm-Hybridtechnik für Mikrowellenschaltkreise zur Verbesserung von Empfängerspezifikationen" von G.P. Ferraris; in: Proceedings zu "Verbindungstechnik in der Elektronik - Löten, Schweißen, Kleben", Vorträge und Posterbeiträge des 4. Internationalen Kolloquiums in Fellbach vom 23. bis 25. Februar 1988, Veranstalter: Deutscher Verband für Schweißtechnik e.V. (DVS), Düsseldorf, Seiten 17 bis 22.

Bei dem bekannten Verfahren werden in einem Vakuumprozeß eine erste Widerstandsschicht mit einem hohen Flächenwiderstand, eine zweite Widerstandsschicht mit einem niedrigen Flächenwiderstand und eine elektronisch gut leitende Leitschicht auf ein dielektrisches Substrat aufgebracht. Die erste Widerstandsschicht wird dabei erzeugt durch reaktives Sputtern mit Tantal (Ta) unter Sauerstoff- bzw. Stickstoff-Atmosphäre, was zur Ablagerung einer Tantaloxynitridschicht auf dem Substrat führt, die einen hohen Flächenwiderstand von etwa 320Ω/sq ± 10% besitzt. Die zweite Widerstandsschicht wird erzeugt durch reaktives Sputtern mit Titan (Ti) unter Stickstoff-Athmosphäre, was zur Ablagerung einer Titannitrid- bzw. Titanoxynitridschicht auf der Tantaloxynitridschicht führt; die Titannitrid- bzw. - oxynitridschicht besitzt dabei einen niedrigen Flächenwiderstand von etwa 34Ω/sq ± 10 %.

Ferner sind Siebdruck-Verfahren zur Herstellung von strukturierten Dickschicht-Widerstandsschichtsystemen bekannt, bei dem durch eine Abfolge von mehreren Siebdrucken mit mehreren Pasten mit unterschiedlichen spezifischen Widerstandswerten auf einem Substrat Flächenwiderstände mit unterschiedlichen Widerstandswerten realisiert werden können (vgl. hierzu z.B. den Artikel "Fired-on resistor components" von K. H. Ballard und H. E. Dumesnil, in einer Firmenschrift von E. I. du Pont de Nemours & Company, Perth Amboy, New Jersey, welche sich auf einen am 22.09.60 gehaltenen Vortrag von K. H. Ballard auf dem "American Ceramic Society Meeting" bezieht).

Die Anwendung der Dickschichttechnik ist bislang auf Schaltungsanordnungen im unteren Frequenzbereich beschränkt, da wegen der begrenzten Genauigkeit der Siebdruckverfahren die Erzeugung von insbesondere für den Mikrowellenbereich ausreichend feinen Strukturen mit scharfen Kanten nicht möglich ist. Dies gelingt heutzutage nur mit der Dünnfilmtechnik, jedoch ist die Prozeßführung in dem eingangs beschriebenen Verfahren wegen der Verwendung von Tantalnitrid (TaN) sehr aufwendig.

Die Aufgabe der Erfindung besteht darin, zum einen ein möglichst einfaches Verfahren zur Herstellung eines strukturierten Dünnfilm-Widerstandsschichtsystems auf einem dielektrischen Substrat anzugeben, bei dem eine erste Widerstandsschicht mit einem hohen Flächenwiderstand und eine zweite Widerstandsschicht mit einem niedrigen Flächenwiderstand auf das Substrat aufgebracht werden, und zum anderen eine Schaltungsanordnung mit einem solchen Dünnfilm-Widerstandsschichtsystem zu schaffen, die möglichst gute elektrische Eigenschaften insbesondere im Mikrowellenbereich aufweist.

Die erfindungsgemäße Lösung dieser Aufgabe ist in bezug auf das zu schaffende Herstellungsverfahren durch die kennzeichnenden Merkmale des Patentanspruchs 1 angegeben und in bezug auf die zu schaffende Schaltungsanordnung durch die kennzeichnenden Merkmale des Patentanspruchs 8.

Die erfindungsgemäße Lösung besteht darin, daß eine Nickel-Chrom(NiCr)-Widerstandsschicht als erste Widerstandsschicht und eine Wolfram-Titan (WTi)-Widerstandsschicht als zweite Widerstandsschicht auf das dielektrische Substrat aufgebracht werden.

Ein wesentlicher Vorteil besteht darin, daß mit der NiCr-Widerstandsschicht (Flächenwiderstand typisch etwa 260Ω/sq ± 10%) gleichzeitig auch eine sehr gute Haftung des Widerstandsschichtssystems auf dem Substrat erreicht wird und daß mit der WTi-Widerstandsschicht (Flächenwiderstand typisch etwa 10Ω/sq ± 15%) eine sehr wirksame Diffusionssperrschicht erzeugen wird, die das wechselseitige Diffundieren der Atome und Moleküle aus den Widerstandsschichten in die Leitschicht und umgekehrt der Atome und Moleküle der Leitschicht in die Widerstandsschichten weitgehend reduziert.

Die Erfindung eignet sich insbesondere zur Herstellung von Hybridschaltungen für den Mikrowellenbereich.

Im folgenden wird die Erfindung anhand der beiden Figuren näher erläutert.

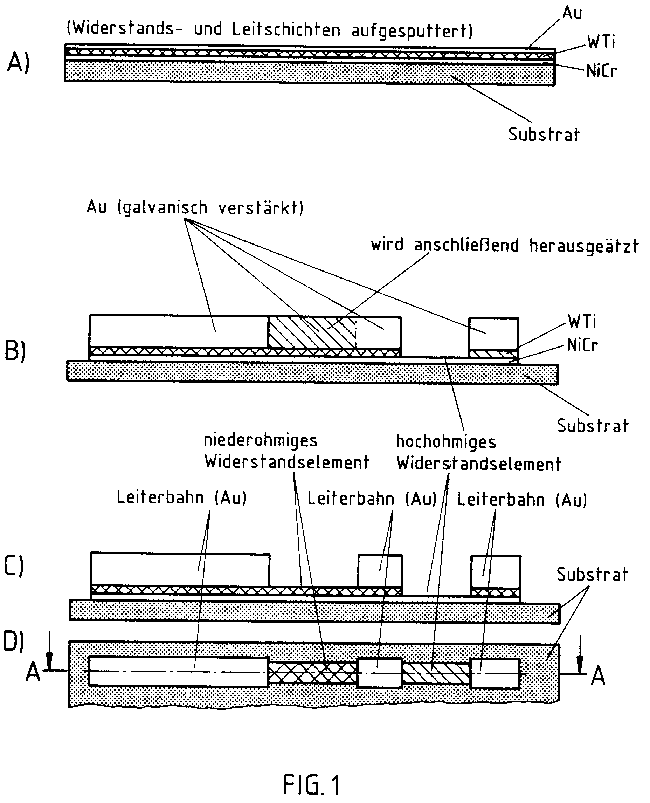

In FIG. 1 werden anhand eines Ausführungsbeispiels einer auf ein dielektrisches Substrat aufgebrachten Leiterbahnstruktur mit einem hochohmigen und mit einem niederohmigen Widerstandselement die wesentlichen Stadien des Herstellungsprozesses nach einer bevorzugten Ausbildung des erfindungsgemäßen Herstellungsverfahrens näher erläutert.

Nach FIG. 1a werden zunächst in einem Vakuumprozeß (hier beispielhaft durch Aufsputtern) nacheinander die Nickel-Chrom(NiCr)-Widerstandsschicht, die Wolfram-Titan(WTi)-Widerstandsschicht und eine Gold(Au)-Schicht (als Leitschicht) auf ein Substrat aufgebracht.

Anschließend wird in einem fotolithographischen Prozeß mit Semiadditivtechnik die gewünschte Struktur erzeugt, indem a) zunächst die Leitschicht mit Ausnahme der die späteren Leitschicht- und Wolfram-Titan(WTi)-Strukturelemente darstellenden Bereiche mit Fotolack abgedeckt wird, anschließend die von Fotolack freien Stellen der Leitschicht galvanisch verstärkt werden und schließlich nach Entfernen des Fotolacks in einem ersten materialselektiven Ätzprozeß zunächst die Leitschicht in den galvanisch nicht verstärkten Bereichen und anschließend in einem zweiten materialselektiven Ätzprozeß die in diesen Bereichen dann freigelegte Wolfram-Titan(WTi)-Widerstandsschicht entfernt werden und indem b) anschließend die die späteren Nickel-Chrom(NiCr)-Strukturelemente darstellenden Bereiche mit Fotolack abgedeckt werden und anschließend die von Fotolack freien Stellen der Nickel-Chrom(NiCr)-Widerstandsschicht in einem dritten materialselektiven Ätzprozeß entfernt werden (vgl. FIG. 1b). Anschließend wird die Fotolackschicht entfernt.

Das niederohmige Widerstandselement aus WTi wird schließlich hergestellt, indem die verbliebenen galvanisch verstärkten Leitschichtstrukturen mit Ausnahme der die späte-ren Wolfram-Titan(WTi)-Strukturelemente darstellenden Bereiche (vgl. schraffierte Fläche in der Gold(Au)-Leitschicht in FIG. 1b) mit Fotolack abgedeckt werden und anschließend die von Fotolack freien Stellen der Leitschicht in einem vierten materialselektiven Ätzprozeß entfernt werden und an diesen Stellen die darunterliegende Wolfram-Titan(WTi)-Widerstandsschicht freigelegt wird.

Zum Schluß wird die verbliebene Fotolackschicht entfernt. Die fertigen Leiterbahnstruktur ist in FIG. 1d in der Draufsicht und in FIG. 1c im Querschnitt entlang der Schnittlinie AA gezeigt.

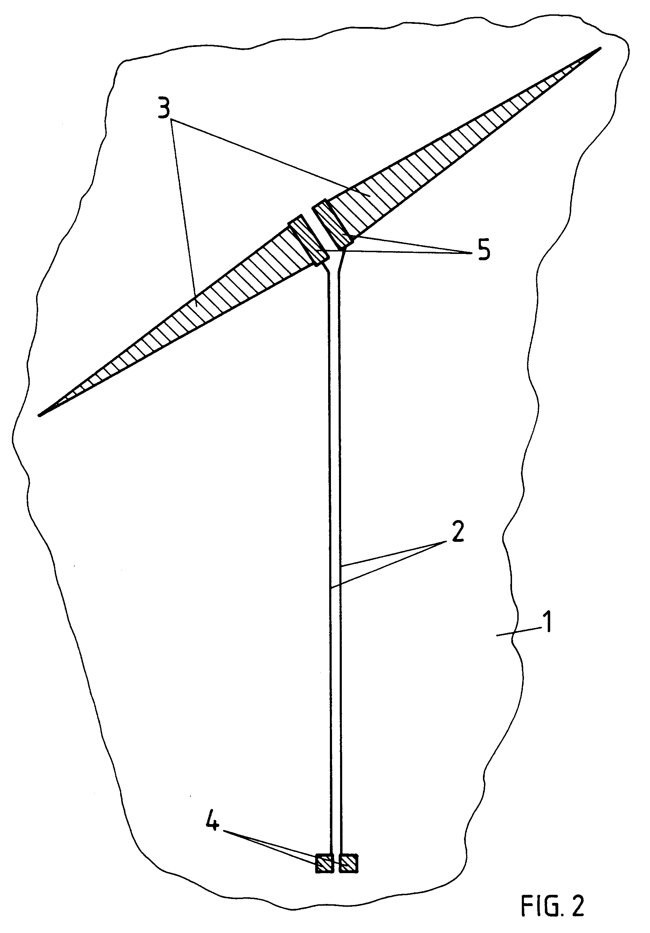

FIG. 2 zeigt beispielhaft eine nach dem erfindungsgemäßen Verfahren hergestellte planare Antenne für den Mikrowellenbereich in der Draufsicht.

Die Antenne ist auf ein (im Ausschnitt gezeigtes) dielektrisches Substrat 1 (z.B. Quarz, Keramik oder ein als elektrischer Isolator wirkendes Polymerkomposit) aufgebracht; sie besteht aus zwei hochohmigen Widerstandsableitungen 2 aus NiCr, (die somit dem hochohmigen Widerstandselement in FIG. 1 entsprechen), die zwei Spannungsabgriffe 4 (z.B. aus Gold oder Silber oder Aluminium oder Kupfer) mit Anschlußstellen 5 (ebenfalls z.B. aus Gold oder Silber oder Kupfer) verbinden (die Spannungsabgriffe 4 und die Anschlußstellen 5 entsprechen somit den Leiterbahnen in FIG. 1). An den Anschlußstellen schließt sich eine aus zwei Teilen bestehende niederohmige Antenne 3 aus WTi an (die somit dem niederohmigen Widerstandselement in FIG. 1 entspricht).

Die Erfindung ist nicht auf die geschilderten Ausführungsbeispiele beschränkt, sondern kann sinngemäß auf weitere übertragen werden.

So können beispielsweise - alternativ zu dem anhand der Figuren beschriebenen Herstellungsverfahren - die in den Figuren gezeigte Leiterbahnstrukturen auch auf folgende Weise hergestellt werden:

Zunächst werden in dem Vakuumprozeß, vorzugsweise in Form eines Sputter- oder Aufdampfprozesses, nacheinander die Nickel-Chrom(NiCr)-Widerstandsschicht, die Wolfram-Titan(WTi)-Widerstandsschicht und die Leitschicht auf das Substrat aufgebracht;

Anschließend wird in einem fotolithographischen Prozeß mit Semiadditivtechnik die gewünschte Struktur erzeugt:
- indem zunächst die Leitschicht mit Ausnahme der die späteren Leitschicht-Strukturelemente darstellenden Bereiche mit Fotolack abgedeckt wird, anschließend die von Fotolack freien Stellen der Leitschicht galvanisch verstärkt werden und schließlich nach dem Entfernen des Fotolacks in einem ersten materialselektiven Ätzprozeß die Leitschicht in den galvanisch nicht verstärkten Bereichen entfernt wird,
- indem anschließend die die späteren Wolfram-Titan(WTi)-Widerstandselemente darstellenden Bereiche mit Fotolack abgedeckt werden und anschließend die von Fotolack freien Stellen der Wolfram-Titan(WTi)-Widerstandsschicht in einem zweiten materialselektiven Ätzprozeß entfernt werden und an diesen Stellen die darunter liegende Nickel-Chrom(NiCr)-Widerstandsschicht freigelegt wird,
- indem schließlich zusätzlich die die späteren Nickel-Chrom(NiCr)-Widerstandselemente darstellenden Bereiche mit Fotolack abgedeckt werden und anschließend die von Fotolack freien Stellen der Nickel-Chrom(NiCr)-Widerstandsschicht in einem dritten materialselektiven Ätzprozeß entfernt werden.

Abschließend wird die verbliebene Fotolackschicht entfernt.

Möglich ist auch folgende Abwandlung in der Herstellung:
Zunächst werden in dem Vakuumprozeß, vorzugsweise in Form eines Sputter- oder Aufdampfprozesses, nacheinander die Nickel-Chrom(NiCr)-Widerstandsschicht, die Wolfram-Titan(WTi)-Widerstandsschicht und die Leitschicht auf das Substrat aufgebracht.

Anschließend wird in einem fotolithographischen Prozeß die gewünschte Struktur in der Leitschicht erzeugt:
- indem zunächst die die spätere Struktur (einschließlich der Widerstandselemente) darstellenden Bereiche der Leitschicht mit Fotolack abgedeckt werden und anschließend in einem ersten materialselektiven Ätzprozeß die von Fotolack freien Stellen der Leitschicht entfernt werden und an diesen Stellen die darunterliegende Wolfram-Titan(WTi)-Widerstandsschicht freigelegt wird;
- indem anschließend der Fotolack bis auf die die späteren Wolfram-Titan(WTi)-Widerstandselemente darstellenden Bereiche entfernt wird und danach in einem zweiten materialselektiven Ätzprozeß die von Fotolack freien Stellen der Wolfram-Titan(WTi)-Widerstandsschicht entfernt werden und an diesen Stellen die darunterliegende Nickel-Chrom(NiCr)-Widerstandsschicht freigelegt wird;
- indem schließlich zusätzlich die die späteren Nickel-Chrom(NiCr)-Widerstandselemente darstellenden Bereiche mit Fotolack abgedeckt werden und anschließend die von Fotolack freien Stellen der Nickel-Chrom(NiCr)-Widerstandsschicht in einem dritten materialselektiven Ätzprozeß entfernt werden.

Abschließend wird die verbliebene Fotolackschicht entfernt.

## Patentansprüche

1. Verfahren zur Herstellung eines strukturierten Dünnfilm-Widerstandschichtsystem auf einem dielektrischem Substrat, bei welchem Verfahren in einem Vakuumprozeß eine erste Widerstandsschicht mit einem hohen Flächenwiderstand, eine zweite Widerstandsschicht mit einem niedrigen Flächenwiderstand und eine elektrisch gut leitende Leitschicht auf das Substrat aufgebracht werden, dadurch gekennzeichnet, daß eine Nickel-Chrom(NiCr)-Widerstandsschicht als erste Widerstandsschicht und eine Wolfram-Titan(WTi)-Widerstandsschicht als zweite Widerstandsschicht auf das dielektrische Substrat aufgebracht werden.

2. Verfahren nach Anspruch 1, gekennzeichnet durch die Abfolge folgender Verfahrensschritte:
a) Zunächst werden in dem Vakuumprozeß, vorzugsweise in Form eines Sputter- oder Aufdampfprozesses, nacheinander die Nickel-Chrom(NiCr)-Widerstandsschicht, die Wolfram-Titan(WTi)-Widerstandsschicht und die Leitschicht auf das Substrat aufgebracht;
b) anschließend wird in einem fotolithographischen Prozeß mit Semiadditivtechnik die gewünschte Struktur erzeugt:
ba) indem zunächst die Leitschicht mit Ausnahme der die späteren Leitschicht- und Wolfram-Titan(WTi)-Strukturelemente darstellenden Bereiche mit Fotolack abgedeckt wird, anschließend die von Fotolack freien Stellen der Leitschicht galvanisch verstärkt werden und schließlich nach Entfernen des Fotolacks in einem ersten materialselektiven Ätzprozeß zunächst die Leitschicht in den galvanisch nicht verstärkten Bereichen und anschließend in einem zweiten materialselektiven Ätzprozeß die in diesen Bereichen dann freigelegte Wolfram-Titan(WTi)-Widerstandsschicht entfernt werden;
bb) indem anschließend die die späteren Nickel-Chrom(NiCr)-Strukturelemente darstellenden Bereiche mit Fotolack abgedeckt werden und anschließend die von Fotolack freien Stellen der Nickel-Chrom(NiCr)-Widerstandsschicht in einem dritten materialselektiven Ätzprozeß entfernt werden und daran anschließend die verbliebene Fotolackschicht entfernt wird;
bc) indem schließlich die verbliebenen galvanisch verstärkten Leitschichtstrukturen mit Ausnahme der die späteren Wolfram-Titan(WTi)-Strukturelemente darstellenden Bereiche mit Fotolack abgedeckt werden und anschließend die von Fotolack freien Stellen der Leitschicht in einem vierten materialselektiven Ätzprozeß entfernt werden und an diesen Stellen die darunterliegende Wolfram-Titan(WTi)-Widerstandsschicht freigelegt wird;
c) schließlich wird die verbliebene Fotolackschicht entfernt.

3. Verfahren nach Anspruch 1, gekennzeichnet durch die Abfolge folgender Verfahrensschritte:
a) Zunächst werden in dem Vakuumprozeß, vorzugsweise in Form eines Sputter- oder Aufdampfprozesses, nacheinander die Nickel-Chrom(NiCr)-Widerstandsschicht, die Wolfram-Titan(WTi)-Widerstandsschicht und die Leitschicht auf das Substrat aufgebracht;
b) anschließend wird in einem fotolithographischen Prozeß mit Semiadditivtechnik die gewünschte Struktur erzeugt:
ba) indem zunächst die Leitschicht mit Ausnahme der die späteren Leitschicht-Strukturelemente darstellenden Bereiche mit Fotolack abgedeckt wird, anschließend die von Fotolack freien Stellen der Leitschicht galvanisch verstärkt werden und schließlich nach Entfernen des Fotolacks in einem ersten materialselektiven Ätzprozeß die Leitschicht in den galvanisch nicht verstärkten Bereichen entfernt wird;
bb) indem anschließend die die späteren Wolfram-Titan(WTi)-Widerstandselemente darstellenden Bereiche mit Fotolack abgedeckt werden und anschließend die von Fotolack freien Stellen der Wolfram-Titan(WTi)-Widerstandsschicht in einem zweiten materialselektiven Ätzprozeß entfernt werden und an diesen Stellen die darunter liegende Nickel-Chrom(NiCr)-Widerstandsschicht freigelegt wird;
bc) indem schließlich zusätzlich die die späteren Nickel-Chrom(NiCr)-Widerstandselemente darstellenden Bereiche mit Fotolack abgedeckt werden und anschließend die von Fotolack freien Stellen der Nickel-Chrom(NiCr)-Widerstandsschicht in einem dritten materialselektiven Ätzprozeß entfernt werden;
c) schließlich wird die verbliebene Fotolackschicht entfernt.

4. Verfahren nach Anspruch 1, gekennzeichnet durch die Abfolge folgender Verfahrensschritte:
a) zunächst werden in dem Vakuumprozeß, vorzugsweise in Form eines Sputter- oder Aufdampfprozesses, nacheinander die Nickel-Chrom(NiCr)-Widerstandsschicht, die Wolfram-Titan(WTi)-Widerstandsschicht und die Seitschicht auf das Substrat aufgebracht;
b) anschließend wird in einem fotolithographischen Prozeß die gewünschte Struktur in der Leitschicht erzeugt:
ba) indem zunächst die die spätere Struktur darstellenden Bereiche der Leitschicht einschließlich der Widerstandselemente mit Fotolack abgedeckt werden und anschließend in einem ersten materialselektiven Ätzprozeß die von Fotolack freien Stellen der Leitschicht entfernt werden und an diesen Stellen die darunterliegende Wolfram-Titan(WTi)-Widerstandsschicht freigelegt wird;
bb) indem anschließend der Fotolack bis auf die die späteren Wolfram-Titan(WTi)-Widerstandselemente darstellenden Bereiche entfernt wird und danach in einem zweiten materialselektiven Ätzprozeß die von Fotolack freien Stellen der Wolfram-Titan(WTi)-Widerstandsschicht entfernt werden und an diesen Stellen die darunterliegende Nickel-Chrom(NiCr)-Widerstandsschicht freigelegt wird;
bc) indem schließlich zusätzlich die die späteren Nickel-Chrom(NiCr)-Widerstandselemente darstellenden Bereiche mit Fotolack abgedeckt werden und anschließend die von Fotolack freien Stellen der Nickel-Chrom(NiCr)-Widerstandsschicht in einem dritten materialselektiven Ätzprozeß entfernt werden;
c) schließlich wird die verbliebene Fotolackschicht entfernt.

5. Verfahren nach einem der Ansprüche 2 oder 3, dadurch gekennzeichnet, daß die Leitschicht an den vorgesehenen Stellen in ihrer Schichtdicke auf einen Wert aus dem Bereich von etwa 3-8µm, insbesondere von etwa 4-6µm, vorzugsweise jedoch auf einen Wert von etwa 5µm galvanisch verstärkt wird.

6. Verfahren nach einem der vorhergehenden Ansprüche, dadurch gekennzeichnet, daß eine Gold(Au)- oder Silber(Ag) oder Aluminium(Al)- oder Kupfer(Cu)-Schicht als Leitschicht aufgebracht wird.

7. Verfahren nach einem der vorhergehenden Ansprüche, dadurch gekennzeichnet, daß Quarz oder Keramik oder ein als elektricher Isolator wirkendes Polymerkomposit als Substratmaterial verwendet wird.

8. Schaltungsanordnung mit einem insbesondere nach dem Verfahren der vorhergehenden Ansprüche hergestellten Dünnfilm-Widerstandsschichtsystem, welches Widerstandsschichtsystem auf ein dielektrisches Substrat aufgebracht ist und aus einer ersten Widerstandsschicht mit einem hohen Flächenwiderstand, einer zweiten Widerstandsschicht mit einem niedrigen Flächenwiderstand und einer elektrisch gut leitenden Leitschicht besteht, dadurch gekennzeichnet, daß die erst Widerstandsschicht aus Nickel-Chrom(NiCr) besteht und die zweite Widerstandsschicht aus Wolfram-Titan(WTi).

9. Schaltungsanordnung nach Anspruch 8, dadurch gekennzeichnet, daß die Leitschicht aus Gold(Au) oder Silber(Ag) oder Kupfer(Cu) besteht und ihre Schichtdicke vorzugsweise im Bereich von etwa 3-8µm, insbesondere von etwa 4-6µm, insbesondere von etwa 5µm liegt.

10. Schaltungsanordnung nach einem der Ansprüche 8 oder 9, dadurch gekennzeichnet, daß das Substrat aus Quarz oder Keramik oder aus einem als elektrischer Isolator wirkenden Polymerkomposit besteht.
